Europäisches Patentamt

European Patent Office

Office européen des brevets

(11) Veröffentlichungsnummer: **0 059 268**
**A1**

(12) # EUROPÄISCHE PATENTANMELDUNG

(21) Anmeldenummer: **81110637.6**

(22) Anmeldetag: **21.12.81**

(51) Int. Cl.³: **H 03 J 3/26**
**H 03 H 7/09**

(30) Priorität: **25.02.81 DE 3106997**

(43) Veröffentlichungstag der Anmeldung:
**08.09.82 Patentblatt 82/36**

(84) Benannte Vertragsstaaten:
**AT FR IT**

(71) Anmelder: **Blaupunkt-Werke GmbH**
**Robert-Bosch-Strasse 200**
**D-3200 Hildesheim(DE)**

(72) Erfinder: **Heindorf, Willi**
**Heinrich-Zille-Strasse 6**
**D-3212 Gronau(DE)**

(72) Erfinder: **Ohler, Michael**
**In der Dehne 4**
**D-3211 Despetal(DE)**

(74) Vertreter: **Eilers, Norbert, Dipl.-Phys.**
**Blaupunkt-Werke GmbH Robert-Bosch-Strasse 200**
**D-3200 Hildesheim(DE)**

(54) **Tuner für Fernsehempfangsgerät.**

(57) Es wird ein Tuner für Fernsehempfangsgeräte mit einer Vorstufe (2) und einer der Vorstufe über ein durchstimmbares, mehrkreisiges Bandfilter (4-6) nachgeschalteten Mischstufe (7) vorgeschlagen, dessen Bandfilter zur Verbesserung der Nachbarkanalselektion mindestens drei durchstimmbare Kreise aufweist.

EP 0 059 268 A1

Croydon Printing Company Ltd.

**BLAUPUNKT-WERKE GMBH** 32 HILDESHEIM, Robert-Bosch-Straße 200

PLI-Hi Gebranzig/TEX1-Li          - 1 -                    18.2.1981
                                                          (R.Nr. 1689)

Stand der Technik

Die vorliegende Erfindung betrifft einen Tuner für Fernsehempfangsgeräte mit einer Vorstufe und einer der Vorstufe über ein durchstimmbares mehrkreisiges Bandfilter nachgeschalteten Mischstufe.

Tuner dieser Art, die üblicherweise zweikreisige, über den Empfangsfrequenzbereich durchstimmbare Bandfilter aufweisen, sind hinsichtlich ihres Großsignalverhaltens, insbesondere hinsichtlich der
Nachbarkanalselektion verbesserungswürdig.

Die Erfindung und ihre Vorteile

Die Aufgabe, einen Tuner der eingangs erwähnten Art zu entwickeln,
der bei einfachem Aufbau eine hohe Nachbarkanalselektion aufweist,
wird gemäß der vorliegenden Erfindung dadurch gelöst, daß das Bandfilter mindestens drei durchstimmbare Kreise aufweist.

Gemäß einer vorteilhaften Ausbildung der Erfindung, welche einen
einfachen Aufbau eines erfindungsgemäßen Tuners mit geringer Durchgangsdämpfung ermöglicht, wird das Bandfilter als Dreikreisbandfilter ausgebildet.

Ein einfacher Aufbau derartiger Tuner bei guter Nachbarkanalselektion und geringer Durchgangsdämpfung läßt sich gemäß vorteilhafter
Ausgestaltung der Erfindung dadurch erzielen, daß die Kreise der
Bandfilter als $\lambda/4$-Kreise oder $\lambda/2$-Kreise ausgebildet werden.

Gemäß einer vorteilhaften Weiterbildung der Erfindung läßt sich
ein frequenzmäßig großer Abstimmbereich des Bandfilters bei gutem
Gleichlauf der einzelnen Kreise dadurch erzielen, daß die Kreise
des Bandfilters mit Kapazitätsdioden durchstimmbar sind und den
Kapazitätsdioden jeweils eine Serienschaltung aus einem Kondensator
und einer Induktivität parallel geschaltet wird.

0059268

Die Vorteile der vorliegenden Erfindung liegen insbesondere darin,
daß aufgrund des Einsatzes eines mindestens dreikreisigen steilflankigen Bandfilters neben einer hohen Nachbarkanalselektion die
Großsignalfestigkeit des Tuners auch hinsichtlich der Kreuzmodulationsfestigkeit und Intermodulationsfestigkeit gegenüber herkömmlichen, zum Stand der Technik gehörenden Tunern deutlich verbessert wird, da durch das Bandfilter nur der etwa 6 MHz breite
für den Fernsehempfang erforderliche Frequenzbereich an die Mischstufe gelangt, während Signale aus Frequenzbereichen, welche in
der Mischstufe zu störenden Kreuzmodulationserscheinungen und
Intermodulationserscheinungen führen könnten, durch das erfindungsgemäß vorgesehene Bandfilter von der Mischstufe ferngehalten werden.

Darüber hinaus werden aufgrund des erfindungsgemäßen Einsatzes eines
mindestens dreikreisigen steilflankigen Bandfilters die Ausgangssignale der Mischstufe vom Eingang des Tuners ferngehalten, so daß
insbesondere die Ausgangssignale des Mischoszillators der Mischstufe nicht an den Eingang des Tuners gelangen und somit von einem
erfindungsgemäßen Tuner keine unerwünschten Störstrahlungen ausgehen können.

Zeichnung

Die Erfindung wird nachfolgend an einer Figur näher erläutert.

In dieser Figur ist ein erfindungsgemäßer Tuner in einem Blockschaltbild dargestellt, wobei das erfindungsgemäß zwischen der
Vorstufe und der Mischstufe angeordnete steilflankige Bandfilter
in Einzelheiten dargestellt ist.

# BLAUPUNKT-WERKE GMBH 32 HILDESHEIM, Robert-Bosch-Straße 200

PLI-Hi Gebranzig/TEX1-Li — 3 — 18.2.1981
(R.Nr. 1689)

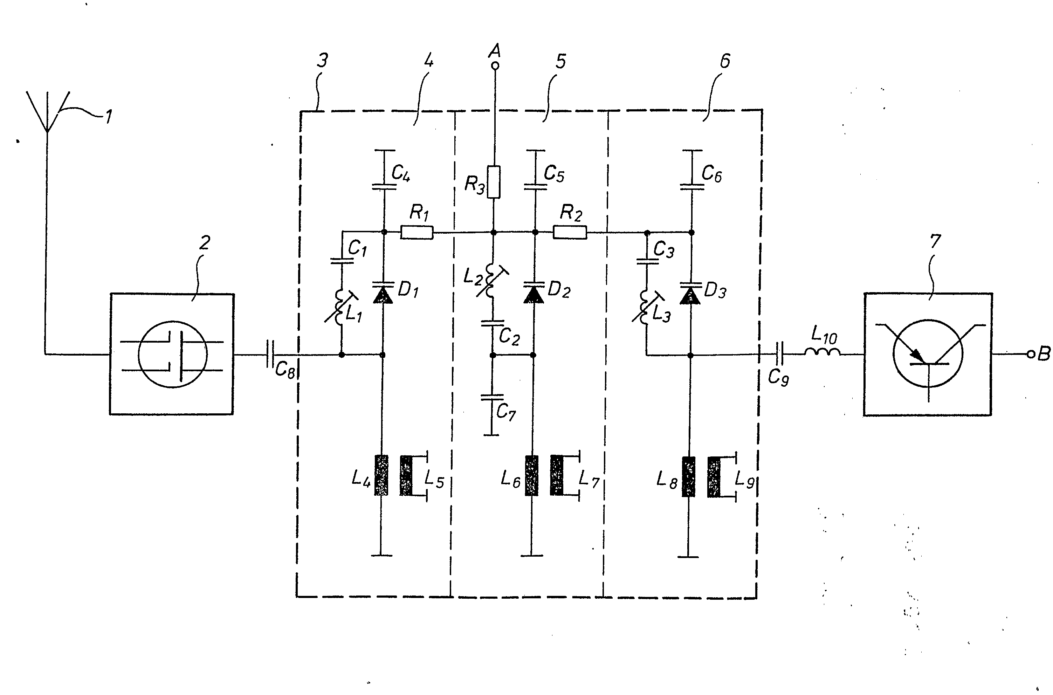

Die Fernsehsignale werden mit der Antenne 1 empfangen und gelangen von der Antenne 1 in die Vorstufe 2. Die Vorstufe 2 weist ein in der Figur nicht näher dargestellten und der Vorselektion dienenden über den Empfangsfrequenzbereich durchstimmbaren Vorkreis auf, der dem beispielsweise als Dual-Gate MOSFET ausgebildeten Vorstufentransistor vorgeschaltet ist. Die Erfindung läßt sich z. B. auch auf Tuner anwenden, deren Vorstufe ein PIN-Dioden-Dämpfungsglied mit einem nachgeschalteten, in Basisschaltung betriebenen ungeregelten Hochstromtransistor aufweist.

Der Vorstufe 2 ist über den Koppelkondensator $C_8$ das durchstimmbare Bandfilter 3 nachgeschaltet. Das Bandfilter 3 besteht aus den drei einzelnen durchstimmbaren Kreisen 4, 5 und 6.

Der durchstimmbare Kreis 4 wird von den Induktivitäten $L_4$ und $L_5$, der Kapazitätsdiode $D_1$ und dem Kondensator $C_4$ gebildet. Die Serienschaltung aus dem Kondensator $C_1$ und der Induktivität $L_1$ vergrößert den mit der Kapazitätsdiode $D_1$ durchstimmbaren Hubbereich des durchstimmbaren Kreises 4.

Entsprechend bilden die Induktivitäten $L_6$, $L_7$ und $L_2$ die Kapazitätsdiode $D_2$ und die Kondensatoren $C_2$, $C_5$ und $C_7$ den durchstimmbaren Kreis 5 und die Induktiviäten $L_8$, $L_9$ und $L_3$ die Kapazitätsdiode $D_3$ und die Kondensatoren $C_3$ und $C_6$ den durchstimmbaren Kreis 6.

Die Kreise 4, 5 und 6 sind bei dem in der Figur dargestellten Ausführungsbeispiel der Erfindung als durchstimmbare $\lambda/4$-Kreise ausgebildet.

BLAUPUNKT-WERKE GMBH 32 HILDESHEIM, Robert-Bosch-Straße 200

PLI-Hi Gebranzig/TEX1-Li          - 4 -          18.2.1981
                                                 (R.Nr. 1689)

Die Kapazitätsdioden $D_1$, $D_2$ und $D_3$ erhalten über den Anschluß-punkt A und die Widerständen $R_1$, $R_2$ und $R_3$ die Abstimmspannung zum Durchstimmen der Kreise 4, 5 und 6. Mit dieser Abstimmspannung läßt sich auch der in der Figur nicht dargestellte Vorkreis der Vorstufe und der Mischoszillator der Mischstufe 7 durchstimmen.

Die Ausgangssignale des Bandfilters 3 gelangen über die der Anpassung dienende Serienschaltung aus dem Kondensator $C_9$ und der Induktivität $L_{10}$ in die Mischstufe 7, an deren Ausgang B die zwischenfrequenten Ausgangssignale des Tuners anstehen.

Die frequenzbestimmenden Induktivitäten der abstimmbaren in $\lambda/4$-Technik aufgebauten Kreise 4, 5 und 6 werden im wesentlichen von den Induktitiväten $L_4$, $L_5$, $L_6$, $L_7$, $L_8$ und $L_9$ gebildet, die bei-spielsweise als versilberte Drahtbügel ausgebildet sein können. Durch Veränderung der Abstände der Induktivitäten $L_4$ und $L_5$, $L_6$ und $L_7$ sowie $L_8$ und $L_9$ zueinander ist ein Abgleich der einzelnen Kreise 4, 5 und 6 des Bandfilters 3 möglich. Die Kopplung der Kreise 4, 5 und 6 erfolgt im wesentlichen aufgrund der Kopplung der vorgenannten Induktivitäten untereinander.

Es liegt durchaus im Rahmen der vorliegenden Erfindung, das min-destens dreikreisige Bandfilter sowohl direkt zwischen die Vor-stufe und die Mischstufe wie in der Figur dargestellt zu legen als auch zwischen die Vorstufe und eine der Mischstufe vorgeschaltete Trennstufe oder zwischen eine derartige Trennstufe und die Misch-stufe zu legen.

Als Mischstufen kommen sowohl selbstschwingende Mischstufen als auch Mischstufen mit einem separaten Mischoszillator in Betracht.

# BLAUPUNKT-WERKE GMBH 32 HILDESHEIM, Robert-Bosch-Straße 200

PLI-Hi Gebranzig/TEX1-Li          - 5 -          18.2.1981
                                                  (R.Nr. 1689)

Die hervorragende Großsignalfestigkeit erfindungsgemäßer Tuner hat ihre Ursache insbesondere in der hohen Selektivität der erfindungsgemäß zwischen der Vorstufe und der Mischstufe vorzusehenden mindestens    dreikreisigen Bandfilter .

Aufgrund der hohen Selektivität dieser den Mischstufen erfindungsgemäß vorgeschalteten mindestens dreikreisigen Bandfilter können in erfindungsgemäß aufgebauten Tunern auch Mischstufen eingesetzt werden, die hinsichtlich ihrer Kreuzmodulationsfestigkeit und Intermodulationsfestigkeit geringeren als sonst bei Tunern üblichen Anforderungen genügen, ohne daß die Großsignalfestigkeit eines erfindungsgemäßen Tuners merklich gemindert wird.

Darüber hinaus kann bei erfindungsgemäßen Tunern aufgrund des der Mischstufe vorgeschalteten mindestens dreikreisigen Bandfilters auf zusätzliche Maßnahmen zur Dämpfung des Ausgangssignals des Mischoszillators auf dem Weg zum Eingang des Tuners verzichtet werden.

Erfindungsgemäße Tuner sind insbesondere für den UHF-Bereich aber auch für den VHF-Bereich geeignet, sie weisen einen einfachen Aufbau auf und sind insbesondere zum Empfang in Fernsehsendernetzen mit einer Vielzahl von Einzelsendern, wie beispielsweise beim Kabelfernsehen, geeignet. Ferner gehen von erfindungsgemäß aufgebauten Tunern keine unerwünschten Störstrahlungen, die ihren Ursprung in der Mischstufe haben könnten, aus.

Tuner für Fernsehempfangsgerät

Ansprüche

1. Tuner für Fernsehempfangsgeräte mit einer Vorstufe und einer der Vorstufe über ein durchstimmbares mehrkreisiges Bandfilter nachgeschalteten Mischstufe, dadurch gekennzeichnet, daß das Bandfilter (3) mindestens drei durchstimmbare Kreise (4, 5, 6) aufweist.

2. Tuner nach Anspruch 1, dadurch gekennzeichnet, daß das Bandfilter (3) als Dreikreisbandfilter (4, 5, 6) ausgebildet ist.

3. Tuner nach einem der Ansprüche 1 und 2, dadurch gekennzeichnet, daß die Kreise (4, 5, 6) des Bandfilters (3) als $\lambda/4$-Kreise (4, 5, 6) ausgebildet sind.

4. Tuner nach einem der Ansprüche 1 und 2, dadurch gekennzeichnet, daß die Kreise des Bandfilters (3) als $\lambda/2$-Kreise ausgebildet sind.

5. Tuner nach einem der Ansprüche 1 bis 4, dadurch gekennzeichnet, daß die Kreise (4, 5, 6) des Bandfilters (3) mit Kapazitätsdioden ($D_1$, $D_2$, $D_3$) durchstimmbar sind und den Kapazitätsdioden ($D_1$, $D_2$, $D_3$) jeweils eine Serienschaltung aus einem Kondensator ($C_1$, $C_2$, $C_3$) und einer Induktivität ($L_1$, $L_2$, $L_3$) parallel geschaltet ist.

Europäisches
Patentamt

**EUROPÄISCHER RECHERCHENBERICHT**

0059268

Nummer der Anmeldung

EP 81 11 0637

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | GB-A-1 210 511 (MULLARD) <br> * Seite 1, Zeilen 13-84; Seite 2, Zeile 31 - Seite 3, Zeile 22; Seite 6, Zeilen 6-52; Figuren 1-8,12 * | 1,2,4 | H 03 J 3/26 <br> H 03 H 7/09 |
| Y | | 3,5 | |
| Y | FR-A-2 155 273 (SABA) <br> * Seite 1, Zeilen 1-15; Seite 4, Zeile 10 - Seite 7, Zeile 39; Figuren 1-5 * & DE - A - 2146513 | 3 | |
| Y | FR-A-2 303 414 (PHILIPS) <br> * Seite 3, Zeilen 24-33; Figur 1 * & DE - A - 2607195 | 5 | |
| X | US-A-3 110 004 (I.T. POPE) <br> * Spalte 2, Zeilen 9-22; Figur 1 * | 1,2 | **RECHERCHIERTE SACHGEBIETE (Int. Cl. ³)** <br> H 03 J <br> H 03 H |
| X | DE-B-2 744 213 (SIEMENS) <br> * Spalte 2, Zeilen 24-42; Spalte 6, Zeile 57 - Spalte 7, Zeile 18; Figur 3 * | 1,2 | |
| X | US-A-4 153 887 (R. POPPA) <br> * Insgesamt * | 1,2 | |
| A | FR-A-2 451 133 (BLAUPUNKT) <br> & DE - A - 2909319 | | |

Der vorliegende Recherchenbericht wurde für alle Patentansprüche erstellt.

| Recherchenort <br> DEN HAAG | Abschlußdatum der Recherche <br> 13-05-1982 | Prüfer <br> VAN WEEL E.J.G. |
|---|---|---|